# FASCICULE DE BREVET EUROPEEN

(11) **EP 0 870 335 B1**
(45) Date de publication et mention de la délivrance du brevet: **05.03.2003**
(21) Numéro de dépôt: 96942423.3
(22) Date de dépôt: 18.12.1996
(51) Int. Cl.: H01L 31/103, H01L 31/108, H01L 31/0352, H01L 31/115

(54) **DETECTEUR DE RAYONNEMENTS IONISANTS ULTRA-MINCE ET PROCEDES DE REALISATION D'UN TEL DETECTEUR**
ULTRADÜNNER DETEKTOR FÜR IONISIERENDE STRAHLUNG UND VERFAHREN ZUR HERSTELLUNG
ULTRA-THIN IONISING RADIATION DETECTOR AND METHODS FOR MAKING SAME

(30) Priorité: 20.12.1995 FR 9515162
(43) Date de publication de la demande: 14.10.1998
(73) Titulaire: COMMISSARIAT A L'ENERGIE ATOMIQUE, 75015 Paris (FR)
(72) Inventeur: FOULON, François, F-91400 Orsay (FR); SPIRKOVITCH, Serge, F-94300 Vincennes (FR); BABADJIAN, Lionel, F-77600 Chanteloup (FR)
(74) Mandataire: Moutard, Pascal Jean
(86) Numéro de dépôt international: FR9602019
(87) Numéro de publication internationale: WO97023003

(56) Documents cités:
- EP-A- 0 279 492
- EP-A- 0 416 798
- DE-A- 3 333 410
- FR-A- 2 284 989
- PATENT ABSTRACTS OF JAPAN vol. 012, no. 277 (E-640), 30 Juillet 1988 & JP 63 055980 A (MATSUSHITA ELECTRIC WORKS LTD), 10 Mars 1988,
- CLEO '94. SUMMARIES OF PAPERS PRESENTED AT THE CONFERENCE ON LASERS AND ELECTRO-OPTICS. VOL.8. 1994 TECHNICAL DIGEST SERIES. CONFERENCE EDITION (CAT. NO.94CH3463-7), PROCEEDINGS OF 1994 CONFERENCE ON LASERS AND ELECTRO-OPTICS AND THE INTERNATIONAL EL, ISBN 0-7803-1971-0, 1994, WASHINGTON, DC, USA, OPT. SOC. AMERICA, USA, page 22 XP000601776 LIU M Y ET AL: "140 GHz MSM photodetectors in silicon-on-insulator"
- 1992 IEEE NUCLEAR SCIENCE SYMPOSIUM AND MEDICAL IMAGING CONFERENCE (NSS/MIC'92), ORLANDO, FL, USA, 25-31 OCT. 1992, vol. 40, no. 4, pt.1, ISSN 0018-9499, IEEE TRANSACTIONS ON NUCLEAR SCIENCE, AUG. 1993, USA, pages 753-758, XP000601780 DIERICKX B ET AL: "Integration of CMOS-electronics and particle detector diodes in high-resistivity silicon-on-insulator wafers" cité dans la demande

## Description

### DOMAINE TECHNIQUE

La présente invention concerne un détecteur ultra-mince de rayonnements ionisants tels que, par exemple, des photons UV, des photons X et des particules α ou β, et des procédés de réalisation d'un tel détecteur.

Des détecteurs conformes à l'invention, trouvent de nombreuses applications dans la détection de particules chargées ou de neutrons dans des milieux à fort bruit de fond gamma, dans la mesure de temps de vol d'ions lourds ou encore dans la mesure en ligne de flux tels que des flux de rayonnements X, ou de protons.

L'invention trouve aussi des applications pour la réalisation de détecteurs dits "intelligents" formés par un empilement de plusieurs détecteurs dont l'épaisseur est ajustée à divers types de rayonnements à détecter simultanément.

### ÉTAT DE LA TECHNIQUE ANTÉRIEURE

Les détecteurs de radiation à semi-conducteurs fonctionnent sur le principe de collection de charges, formées par des paires électrons-trous, et générées par l'interaction de rayonnements ionisants avec la matière. Ces rayonnements, lorsqu'ils traversent le matériau semi-conducteur, y transfèrent tout ou partie de leur énergie en provoquant la génération des paires électrons-trous. A titre d'exemple une énergie de l'ordre de 3,6 eV est nécessaire pour générer une paire électron-trou dans le silicium.

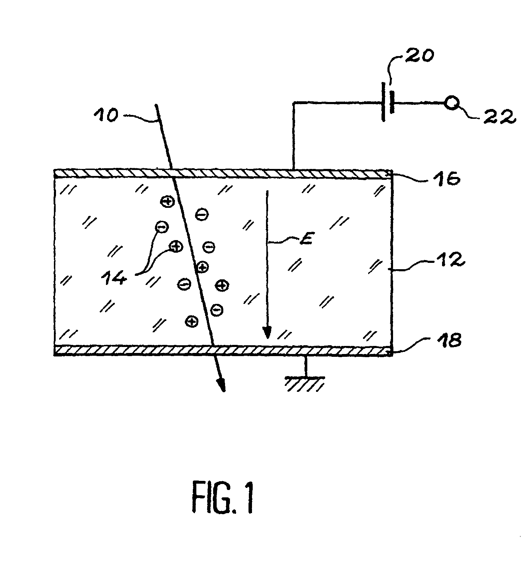

Le schéma de la figure 1 illustre le fonctionnement d'un détecteur au silicium. Lorsqu'un rayonnement ionisant représenté par une flèche 10 traverse un bloc de silicium 12, des paires électrons-trous 14 y sont générées. Des électrodes 16 et 18, recouvrant respectivement des faces opposées du bloc de silicium, sont reliées respectivement à une source de tension 20 et à la masse pour créer au sein du bloc de silicium 12 un champ électrique E. Sous l'effet de ce champ, les charges, c'est-à-dire les électrons et les trous, migrent vers les électrodes 16 et 18 et peuvent être collectés sur les bornes du détecteur, par exemple la borne 22, pour produire un signal électrique qui peut être enregistré.

Si le champ électrique E est constant dans tous le volume du détecteur, pour chaque photon ou chaque particule incidente 10, et quel que soit leur volume d'interaction avec le semi-conducteur, il est possible d'enregistrer aux bornes du détecteur une impulsion électrique proportionnelle à l'énergie que le photon ou la particule ont cédé au silicium. Toutefois, les paires électrons-trous ont naturellement tendance à se recombiner, et le signal n'est égal à l'énergie cédée que si la distance de libre parcours des électrons et des trous avant leur recombinaison est supérieure à l'épaisseur du détecteur.

Le transfert de l'énergie du rayonnement à la matière dépend du type et de l'énergie des radiations incidentes. Ce transfert a lieu suivant différents processus et avec des pertes en énergie différentes. A titre d'illustration, le tableau I ci-après donne des épaisseurs approximatives de silicium (e) nécessaires à l'absorption de 90% de l'énergie des radiations incidents et pour divers types de rayonnements et de particules chargées.

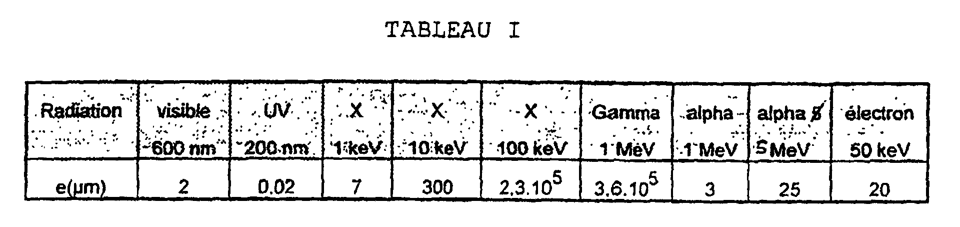

Les pertes en énergie des radiations ont toutefois un caractère statistique et les valeurs citées dans le tableau I correspondent aux épaisseurs moyennes nécessaires à l'absorption de 90% de l'énergie des radiations. Par exemple, un photon gamma de 500 keV traversant un détecteur silicium de 300 µm d'épaisseur (détecteur standard), a une probabilité égale à 7x10⁻⁴ de réaction dans le détecteur entraînant le transfert d'une énergie de 150 à 200 keV au silicium. Dans le cas d'un fort flux de photons gamma de l'ordre de 10⁵ photons par seconde, on enregistre, aux bornes du détecteur, 70 impulsions électriques par seconde correspondant à une perte en énergie des photons dans le détecteur de 150 à 200 keV. On enregistre en fait toute une série d'impulsions correspondant à des pertes en énergie comprises entre 0 et 500 keV.

Dans un certain nombre d'applications des détecteurs à semi-conducteurs il serait souhaitable de disposer de tels détecteurs avec une épaisseur comprise entre 0,1 µm et quelques dizaines de micromètres.

A titre d'exemple lorsqu'un rayonnement comporte plusieurs types de radiations correspondant à des épaisseurs d'absorption très différentes dans le silicium, et que l'on souhaite ne mesurer qu'un seul type de radiation, par exemple celui qui correspond à l'épaisseur d'absorption la plus faible, il convient d'utiliser un détecteur dont l'épaisseur est justement égale ou voisine de cette épaisseur d'absorption.

Par exemple, pour la détection de particules alpha de 1 MeV dans un milieu avec un fort signal parasite de rayonnement gamma, le rapport signal alpha sur signal gamma est optimum pour un détecteur en silicium de l'ordre de 4 µm d'épaisseur, correspondant à l'épaisseur d'absorption des particules alpha. Pour un tel détecteur, toutes les particules alpha perdent la totalité de leur énergie dans le détecteur. Une très faible proportion des photons gamma (<1/1000) subit une interaction avec le détecteur et les photons gamma qui interagissent avec le silicium perdent une très faible quantité d'énergie. Le signal électrique étant directement proportionnel à l'énergie perdue par le rayonnement dans le silicium, le signal alpha est donc bien supérieur au signal gamma.

Une autre application où il est utile de disposer des détecteurs minces est la mesure de rayonnements X, de rayonnements gamma et/ou de particules en ligne, lorsque la radiation perd de façon quasi-uniforme son énergie dans le silicium.

Par exemple pour la mesure en ligne du flux de particules alpha de 5,5 MeV, on souhaite avoir un détecteur tel que les pertes en énergie soient de l'ordre de 100 keV, pour que le comptage des particules soit possible sans une perte en énergie trop importante des particules. En particulier, dans le cas de cet exemple, un détecteur au silicium avec une épaisseur d'environ 0,5 µm conviendrait.

A l'heure actuelle, les détecteurs au silicium à barrière de surface disponibles dans le commerce présentent des épaisseurs supérieures ou égales à environ 10 µm.

Ces détecteurs sont généralement obtenus par amincissement mécanique de plaquettes de silicium ce plusieurs centaines de micromètres d'épaisseur. Pour des raisons de tenue mécanique et de contrôle de l'épaisseur restante il est très difficile de réaliser par amincissement mécanique des détecteurs avec une épaisseur inférieure à 10 µm.

De plus, l'épaisseur des plaquettes n'est contrôlée qu'avec une précisions de l'ordre de +1,5 µm. Ces détecteurs ne sont ainsi pas adaptés aux applications évoquées ci-dessus.

Le document (1) référencé à la fin de la présente description concerne un détecteur de rayonnements avec une diode de détection réalisée dans une couche épaisse de silicium. Ce détecteur est associé à un circuit électronique réalisé dans une couche superficielle de silicium isolée de la couche épaisse de silicium par une couche isolante d'oxyde. L'épaisseur de la couche (100 µm) écarte ce type de détecteur du champ d'application envisagé, qui concerne les détecteurs minces. Le document (2) également référencé à la fin de la description montre un détecteur de radiation avec une isolation thermique, utilisant une diode à structure de type MESA. La technique décrite dans ce document ne permet pas non plus de fabriquer des détecteurs minces. Enfin, le document (3) concerne des photodiodes réalisées dans la couche mince d'un substrat SOI. Ces diodes ne sont cependant pas adaptées à la détection et à la spectrométrie de rayonnements ionisants.

Les documents FR-A-2 284 989 et EP-A-279 492 montrent également des dispositifs photodétecteurs. Ces photodétecteurs ne font cependant pas appel à la technologie silicium sur isolant (SOI).

Enfin, le document "Proceedings of 1994 Conference on Lasers and Electro-optics", vol. 8, 1994, page 22 montre la réalisation d'un photodétecteur dans une couche superficielle d'une structure SOI. Il s'agit cependant d'un détecteur à électrode coplanaires.

Le document JP-A-63 055 980 et l'article "Integration of CMOS electronics and particle detector diodes in high-resistivity silicon-on-insulator waters" de B. Dierickx et al., IEEE Transactions On Nuclear Science, vol.40, n°4, août 1993, pages 753-758 concernant des détecteurs utilisants une structure SOI.

Le document DE-A-3 333 410 (abrégé) concerne un détecteur semiconducteur maintenu dans une ouverture dans un substrat semiconducteur au moyen d'un film d'oxyde.

Finalement, un but de la présente invention est de proposer un détecteur mince avec une épaisseur comprise préférentiellement entre 0,1 et 10 µm. Un autre but est de proposer un détecteur dont l'épaisseur peut être contrôlée avec une grande précision. Un but de l'invention est également de proposer un détecteur ultra-mince utilisable non seulement pour effectuer un comptage du nombre de photons ou de particules chargées reçues, mais aussi pour effectuer une spectroscopie en énergie de ce rayonnement. L'invention a aussi pour but de proposer des procédés simples de réalisation de tels détecteurs. L'invention propose également une méthode de réalisation de détecteurs minces de capacité et de courant d'obscurité faibles par comparaison à ceux obtenus par des techniques conventionnelles.

### EXPOSÉ DE L'INVENTION

Pour atteindre ces buts, l'invention a plus précisément pour objet un détecteur de rayonnements ionisants avec une diode de détection formée dans une couche mince superficielle d'une structure SOI comprenant un empilement d'un substrat de silicium d'une couche isolante d'oxyde de silicium et la couche mince superficielle de silicium, la diode comportant une première et une deuxième couches, dites de jonction, formant avec au moins une portion de couche mince superficielle respectivement une jonction redresseuse et une jonction ohmique et permettant d'établir, par l'application d'une tension, d'un champ électrique de détection dans ladite portion de couche mince, caractérisé en ce que les première et deuxième couches de jonction présentent des faces principales en regard et sensiblement parallèles pour établir un champ électrique sensiblement constant entre elles.

Au sens de la présente invention, on entend par rayonnement ionisant tout rayonnement susceptible de créer des paires électrons-trous. Le rayonnement peut donc être un rayonnement visible, ultraviolet, X, gamma ou encore de particules chargées telles que des particules alpha ou bêta, ou enfin de neutrons après conversion de ces derniers en particules alpha (bore 10) ou bêta (gadolinium).

Par ailleurs, on entend par "jonction redresseuse" soit une jonction de type Schottky, soit une jonction de type pn. Une jonction de type Schottky est encore appelée "contact redresseur" en langage technique courant. Une jonction ohmique est encore qualifiée de "contact ohmique" en langage technique courant.

Grâce aux caractéristiques de l'invention, il est possible d'établir entre les couches de jonction un champ électrique constant dans le volume utile (zone désertée du détecteur). Ce champ électrique constant permet d'obtenir une quantité de charges collectées aux bornes du détecteur qui est proportionnelle à la quantité de charges générées par le rayonnement ionisant. Ainsi, une mesure spectrométrique en énergie est possible.

En effet, la spectrométrie impose soit que la totalité des charges (électrons et trous) générées par le rayonnement ionisant est collectée aux bornes du détecteur, soit que la quantité de charges collectées aux bornes du détecteur est proportionnelle à la quantité de charges générées par le rayonnement ionisant. Dans le premier cas, il faut que la distance de collection des charges (distance parcourue par les charges avant recombinaison) soit supérieure à la distance inter-électrodes, c'est-à-dire la distance entre les première et deuxième couches de jonction. Dans la pratique, cela nécessite généralement l'application aux bornes de la diode d'une tension inverse qui permette de garantir que la distance de collection est supérieure à la distance inter-électrodes dans tout le volume de détection. La distance de collection est alors limitée par les propriétés électriques du silicium à environ 700 µm dans le cas du silicium cristallin de haute pureté. Dans le second cas, lorsqu'on souhaite que la quantité de charges collectées soit proportionnelle à la quantité de charges générées, il faut que la tension appliquée pour polariser en inverse le dispositif conduise à l'établissement d'un champ électrique interne sensiblement constant dans tout le volume utile (zone désertée) du détecteur.

Les détecteurs réalisés dans le cadre de l'invention ont des épaisseurs comprises de préférence entre quelques microns et quelques dizaines de microns. D'un point de vue technique, cette épaisseur est fixée par l'épaisseur de la couche mince du substrat SOI. Par ailleurs, les surfaces de détection sont typiquement comprises entre 100 µm x 100 µm et 1 cm x 1 cm environ. La surface de la diode Schottky ou pn est fixée par la surface du contact Schottky ou de l'interface pn, respectivement. Le volume de détection est défini par la surface de la diode et par l'épaisseur de la diode. Il doit permettre une mesure spectrométrique de l'énergie perdue par le rayonnement incident dans le dispositif de détection. Dans le cas de la détection de particules alpha, la génération charges a lieu le long du parcours de la particule dans une colonne de moins d'un micron de diamètre. Dans le cas de particules bêta et de rayonnement X, la génération de charge a lieu schématiquement dans une sphère dont le rayon dépend de l'énergie du rayonnement incident et qui est de l'ordre de la dizaine de micron. Il apparaît donc clairement que le volume dans lequel sont générées les charges est très petit devant le volume de détection.

Selon une première réalisation de l'invention ladite première couche de jonction est une couche d'un premier métal disposée en contact avec une face libre de la portion de couche mince superficielle et forme avec cette portion de couche une jonction de type Schottky.

Le silicium utilisé pour réaliser la couche mince superficielle est de préférence en silicium de haute résistivité.

Pour détecter les rayonnements traversant la couche mince superficielle, la diode de détection est polarisée en inverse.

L'épaisseur de la couche mince superficielle peut être choisie avantageusement en fonction du type et de l'énergie des rayonnements que l'on souhaite détecter. Cette couche mince n'est pas obtenue par amincissement d'une plaque épaisse mais son épaisseur est fixée par la structure SOI utilisée au départ. Or on sait réaliser, et on trouve dans le commerce, des substrats SOI dont les couches minces superficielles présentent une épaisseur comprise entre 0,1 µm et 100 µm et contrôlée avec une précision de l'ordre de 10%.

Selon une deuxième réalisation du détecteur de l'invention, ladite première couche de jonction est une région de la couche mince superficielle et présente un premier type de conductivité, la région étant en contact avec une seconde région, dite intermédiaire, de la couche mince superficielle, d'un deuxième type de conductivité opposé au premier type de conductivité, et forme avec celle-ci une jonction de type pn.

Le premier type de conductivité est par exemple le type de conductivité n et le deuxième type de conductivité le type p. La région intermédiaire de la couche mince superficielle est ainsi dopée avec des impuretés acceptrices et la conduction se fait par trous libres. La région de détection est alors en silicium dopé avec des impuretés donneuses de type n. La jonction formée est donc une jonction de type pn.

Quelle que soit la réalisation du détecteur, celui-ci peut être équipé d'une prise de contact reliée à la face profonde de la couche mince superficielle et accessible par l'une des faces de la couche superficielle de la structure SOI.

Selon une mise en oeuvre particulière de l'invention applicable à l'une ou l'autre des réalisations du détecteur de l'invention, ladite deuxième couche de jonction est une couche d'un deuxième métal disposée en contact avec une face de la couche mince superficielle opposée à la première couche de jonction, et formant avec la portion de couche superficielle un contact ohmique.

La couche de deuxième métal et la portion de couche superficielle forment également une hétérojonction. Il s'agit cependant d'une hétérojonction non-redresseuse désignée encore par "contact ohmique".

Selon une variante de mise en oeuvre, la deuxième couche de jonction est une région de la couche mince superficielle, dite région de contact, d'un deuxième type de conductivité opposé au premier type de conductivité, la région de contact étant en contact avec la région intermédiaire. La région intermédiaire présente une concentration d'impureté de dopage inférieure à la région de contact.

Dans la réalisation du détecteur avec une jonction de type Schottky la couche superficielle peut comporter une région non intentionnellement dopée en contact avec la couche de premier métal et une région, dite de contact, dopée.

La région de contact, fortement dopée, permet de former une prise de contact conducteur sur la région non intentionnellement dopée. Elle a alors la même fonction que la couche de deuxième métal.

Ainsi le détecteur peut comporter une connexion, accessible par l'une des faces externes de la structure SOI pour la prise de contact, cette connexion traversant la couche mince superficielle ou traversant la couche d'oxyde de silicium et le substrat de silicium.

Selon une réalisation particulière d'un détecteur conforme à l'invention, ladite portion de couche mince superficielle, électriquement isolée, peut présenter au moins deux flancs latéraux opposés, sensiblement parallèles entre eux, et sensiblement perpendiculaires à la couche d'oxyde de silicium. Les première et deuxième couches de matériau de jonction sont alors respectivement situées sur les flancs latéraux opposés.

Selon un aspect avantageux de la réalisation décrite ci-dessus, le détecteur peut présenter au moins une tranchée d'isolation traversant la couche mince superficielle et entourant la portion de couche mince superficielle.

L'invention a également pour objet un procédé de fabrication d'un détecteur tel que décrit ci-dessus. Selon la première réalisation dans laquelle la diode présente une jonction de type Schottky, le procédé peut comporter les étapes suivantes dans lesquelles :
- on forme une couche de matériau isolant électrique sur une face libre d'une couche mince superficielle de silicium d'une structure de type silicium sur isolant (SOI), la structure comprenant un empilement d'un substrat de silicium, d'une couche d'oxyde de silicium et de la couche mince superficielle,
- on pratique dans la couche de matériau isolant électrique une ouverture délimitant une zone de détection,
- on forme une couche de matériau conducteur électrique, en contact avec ladite face libre de la couche superficielle dans l'ouverture, et formant avec la couche superficielle une jonction de type Schottky,
- on grave localement le substrat de silicium et la couche d'oxyde de silicium pour former une ouverture arrière d'accès à la couche superficielle, dans la zone de détection,
- on forme une couche de matériau conducteur électrique en contact avec la couche superficielle dans ladite ouverture arrière d'accès, et formant avec la couche superficielle un contact ohmique.

Selon une autre réalisation, dans laquelle la diode comporte une jonction pn, le procédé peut comporter les étapes suivantes :
a) formation d'une couche de matériau isolant sur une face libre d'une couche superficielle d'une plaque présentant une structure de type SOI et comportant un empilement d'un substrat de silicium, d'une couche d'oxyde de silicium et de la couche mince superficielle de silicium, la couche mince superficielle comportant une première région dopée, d'un premier type de conductivité et ayant une première concentration d'impuretés et une deuxième région dopée du même type de conductivité et avec une deuxième concentration d'impuretés supérieure à la première concentration, la deuxième région étant en contact avec la couche d'oxyde de silicium et enterrée dans la première région,
b) réalisation dans la couche de matériau isolant électrique d'une ouverture délimitant une zone de détection,
c) dopage de la couche mince superficielle dans la zone de détection pour former une troisième région avec des impuretés d'un deuxième type de conductivité opposé au premier type de conductivité.
d) recuit thermique de la plaque,
e) les première, deuxième et troisième régions dopées forment respectivement la région intermédiaire, la région de contact et la région de détection, le procédé comporte en outre la formation de prises de contact électrique sur les deuxième et troisième régions dopées.

Selon un aspect de l'invention, lors de la réalisation de la structure SOI on peut former une couche mince superficielle comportant deux sous-couches empilées qui constituent respectivement les première et seconde régions dopées.

D'autres caractéristiques et avantages de la présente invention ressortiront de la description qui va suivre, en référence aux figures des dessins annexés, donnée à titre purement illustratif et non limitatif.

### BRÈVE DESCRIPTION DES FIGURES

- la figure 1, déjà décrite, est une représentation schématique simplifiée d'un détecteur de rayonnements, expliquant son principe de fonctionnement,
- les figures 2A à 2F sont des coupes, à plus petite échelle, de structures pour la fabrication d'un détecteur de rayonnements conforme à l'invention. Elles illustrent les étapes d'un premier mode de fabrication d'un tel détecteur,
- les figures 3A à 3F sont des coupes de structures pour la fabrication d'un détecteur de rayonnements, conforme à l'invention. Elles illustrent les étapes d'un second mode de fabrication d'un tel détecteur,
- la figure 4 est une coupe schématique d'une réalisation particulière d'un détecteur conforme à l'invention,
- la figure 5 est une vue de dessus de la diode de détection du détecteur de la figure 4,
- les figures 6A à 6E sont des coupes schématiques illustrant des étapes successives d'un troisième mode de fabrication d'un détecteur conforme à l'invention.

### EXPOSÉ DÉTAILLE DE MODES DE REALISATION PARTICULIERS

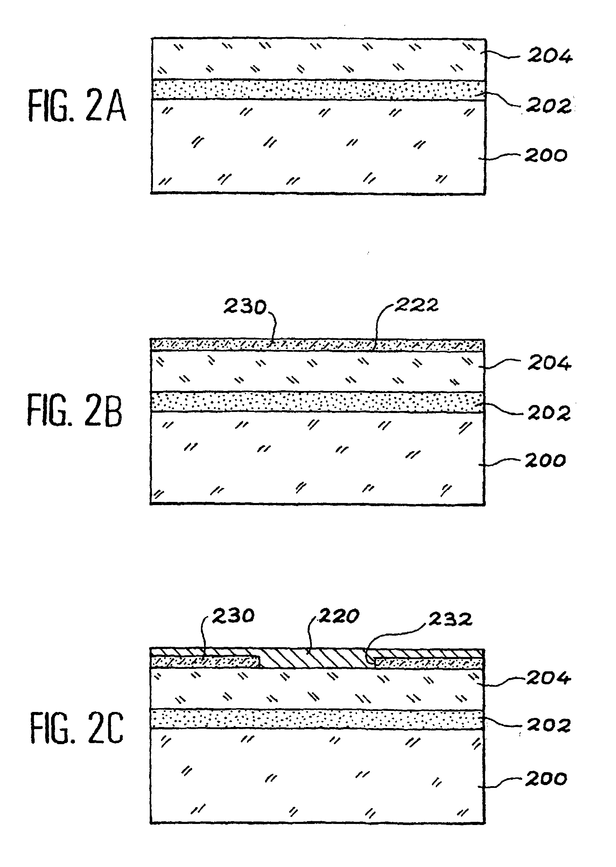

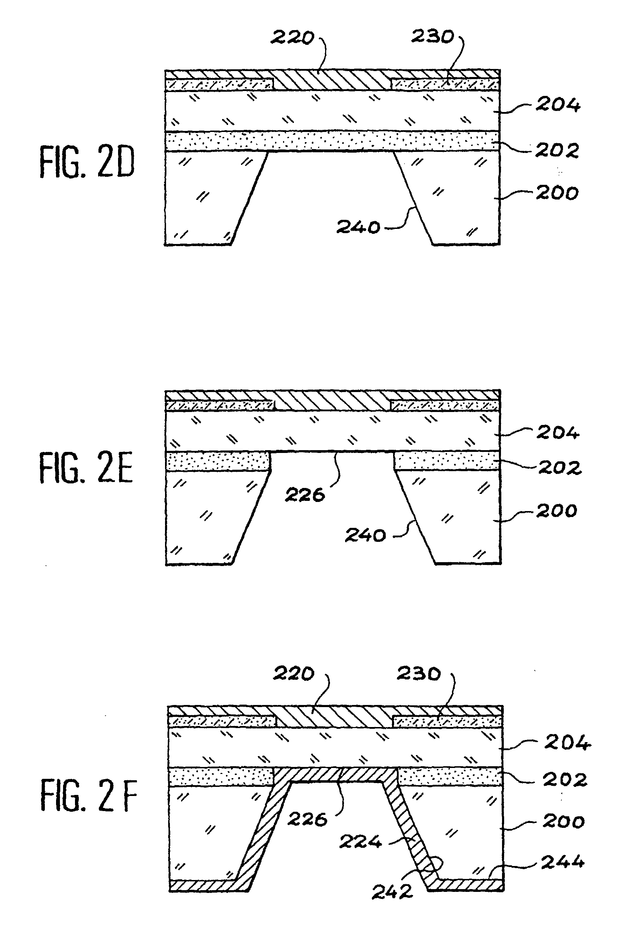

Un procédé de fabrication d'un détecteur conforme à l'invention est illustré par les figures 2A à 2F. Il s'agit en particulier d'un détecteur dans lequel les couches de jonction et de contact sont des couches de métal.

Comme le montre la figure 2A, on part d'un substrat de type silicium sur isolant, ou SOI (silicon on insulator) qui comporte un empilement d'un substrat de silicium 200, d'une couche isolante d'oxyde de silicium 202 et d'une couche mince superficielle 204. Les épaisseurs de ces couches 200, 202, 204 sont, dans l'exemple décrit, respectivement de 300 µm, 0,1 µm et 5 µm.

De façon générale, la couche d'oxyde de silicium 202 présente une épaisseur comprise de préférence entre environ 0,1 et 5 µm. La couche superficielle mince 204, qui est la couche active du détecteur, présente une épaisseur préférentiellement comprise entre 0,1 µm et 100 µm.

L'épaisseur de la couche mince 204 est choisie en particulier en fonction du type et de l'énergie du rayonnement que l'on souhaite détecter.

De telles structures SOI peuvent être réalisées selon des techniques connues. Elles sont par exemple réalisées par implantation d'ions d'oxygène selon un procédé dit SIMOX (Separation by Implanted Oxygen), ou par report direct, selon un procédé dit SDB (Silicon Direct Bonding). De tels structures sont aussi commercialisées sous forme de plaquettes de 6 pouces de diamètre.

Dans le cas de l'exemple décrit la couche superficielle 204 est une couche de silicium de type n de haute résistivité. Sa résistivité est de l'ordre de 100 Ω.cm.

Dans une première étape illustrée à la figure 2B, on dépose sur la couche superficielle 204 une couche 230 de nitrure de silicium d'une épaisseur de l'ordre de 0,2 µm. Cette couche a une fonction d'isolant électrique. Elle est déposée sur la face libre 222 de la couche 204. On pratique ensuite dans la couche 230 une ouverture 232 pour mettre à nu une portion de la couche mince superficielle. L'ouverture 232 est obtenue en mettant en oeuvre des procédés connus de lithographie qui comportent pour l'essentiel le dépôt d'une couche de résine photosensible, la formation d'un masque dans cette résine, avec une ouverture de masque correspondant à l'ouverture que l'on souhaite pratiquer dans la couche de nitrure de silicium, la gravure de la couche de nitrure de silicium à travers l'ouverture de masque, et l'élimination de la résine restante.

L'ouverture 232, visible à la figure 2C, délimite une portion de la couche mince superficielle dans laquelle est réalisée la diode de détection et, par conséquent, une zone de détection du détecteur. Dans une étape suivante une couche d'or 220 avec une densité de l'ordre de 40 µg/cm² est formée par évaporation sur la surface de la couche 230 de nitrure de silicium et dans l'ouverture 232. La couche d'or 220 est en contact avec la portion de la couche mince superficielle 204 dans l'ouverture 232. Elle forme avec la portion de couche mince superficielle une jonction de type Schottky. La couche d'or 220 constitue également une première borne de polarisation de la diode de détection du détecteur.

Comme le montrent les figures 2D et 2E on grave ensuite localement le substrat 200 et la couche isolante 202 afin d'y former une ouverture d'accès 240 à la face 226 de la couche mince superficielle, opposée à la face libre. La gravure de l'ouverture 240 est effectuée dans la zone de détection pour atteindre la portion de la couche mince superficielle dont la face libre est en contact avec la couche d'or 220.

A titre d'indication, le silicium du substrat 200 est gravé à 85°C dans une solution de potasse (KOH) comportant 130g de KOH et 300 ml d'eau. Le nitrure de silicium de la couche 202 est gravé à 20°C avec une solution d'acide fluorhydrique (HF) comportant 10% de HF et 90% d'eau.

Lors des gravures, les portions du substrat et de la couche isolante qui entourent la zone de détection sont protégées par un masque non représenté.

Une dernière étape, correspondant à la figure 2F, comporte la formation d'une couche d'aluminium 224. Cette couche recouvre les flancs 242 de l'ouverture 240, la surface libre 244 du substrat 200 et, en particulier, la face 226 de la portion de la couche mince 204 qui correspond à la zone de détection. La couche d'aluminium 224 présente également une densité de l'ordre de 40 µg/cm² et est déposée par évaporation.

La couche 224 forme avec la couche 204 un contact ohmique et constitue une seconde borne de la diode de détection. Lors du fonctionnement du détecteur une tension de polarisation convenable est donc appliquée entre les couches 220 et 224. La tension appliquée sur la couche d'aluminium 224 est positive par rapport à la tension appliquée à la couche d'or 220 de façon à polariser la jonction en "inverse", c'est-à-dire selon un montage redresseur. C'est aussi sur ces couches 220 et 224 que sont collectées les charges pour la formation d'un signal de détection.

Les détecteurs obtenus selon ce procédé peuvent avoir une couche superficielle suffisamment mince pour ne pas atténuer de façon significative le flux à l'énergie des radiations à détecter. Ils peuvent être appliqués par exemple au contrôle de flux en ligne. Les détecteurs peuvent aussi être utilisée pour le mesure de temps de vol. A titre d'exemple pour des mesures de temps de vol de particules alpha de 5,5 MeV, l'épaisseur de la couche mince superficielle est choisie égale à 0,5 µm, ce qui correspond à une perte en énergie de 100 keV dans chaque détecteur d'une paire de détecteurs. Les détecteurs peuvent enfin être segmentés en une pluralité de pixels de détection, pour déterminer la direction des particules détectées.

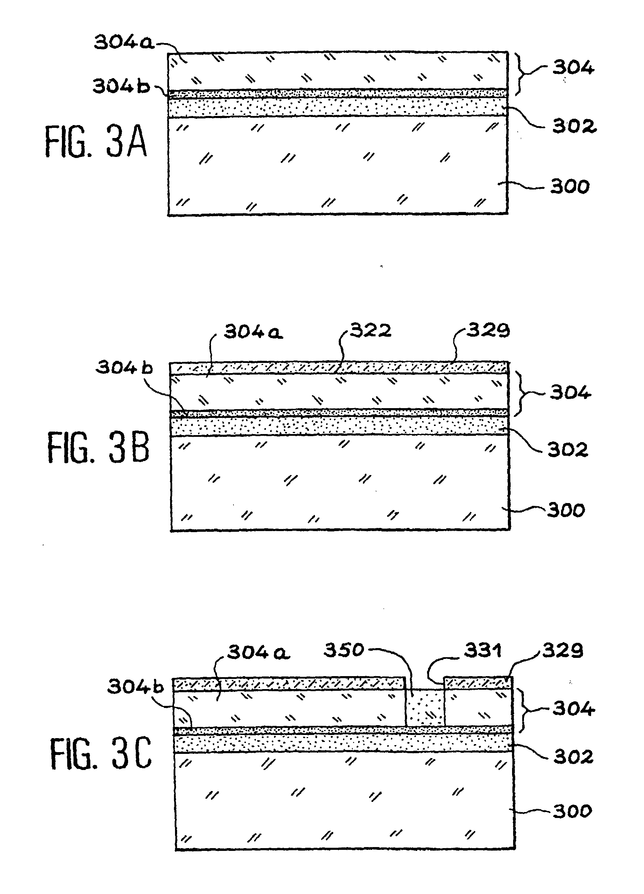

Les figures 3A à 3F illustrent un autre procédé de réalisation d'un détecteur conforme à l'invention. Ce procédé concerne plus particulièrement la réalisation d'un détecteur dans lequel les couches "de jonction" et "de contact" sont en silicium dopé. Des références identiques auxquelles on ajoute 100 sont attribuées à des parties des figures 3A à 3F qui correspondent à des parties identiques ou similaires des figures 2A à 2F.

Comme le montre la figure 3A, on part d'une plaque avec une structure de type SOI qui comprend un substrat de silicium 300, une couche isolante d'oxyde de silicium 302 et une couche mince superficielle 304 de silicium de type p. La couche 304 comporte une première sous-couche 304a qui forme une première région dopée (de type p) de résistivité élevée, et une deuxième sous-couche 304b qui relie la première sous-couche 304a à la couche d'oxyde 302.

La deuxième sous-couche 304b, enterrée sous la sous-couche 304a, forme une deuxième région dopée, également du type p, mais avec une plus forte concentration d'impuretés. Elle présente une plus faible résistivité. Les sous-couches 304a et 304b correspondent respectivement à une région dite intermédiaire et à une région dite de contact du détecteur,

A titre d'indication, les sous-couches 304a et 304b, présentent respectivement une résistivité supérieure à 100 Ω.cm et une résistivité inférieure à 0,1 Ω.cm.

Les sous-couches 304a et 304b peuvent être formées par exemple par implantation d'impuretés de bore dans un substrat SOI dans les étapes de fabrication de substrat par technique SDB (Silicon Direct Bonding). Les plaques des structures SOI munies des sous-couches 304a et 304b sont disponibles dans le commerce.

Une deuxième étape consiste, comme le montre la figure 3B, à former une couche isolante 329 de nitrure de silicium sur la face libre 322 de la couche mince superficielle, en contact avec la sous-couche 304a.

La figure 3C montre la réalisation d'une prise de contact sur la sous-couche 304b qui, dans le présent exemple, constitue la région de contact telle que décrite précédemment. Une ouverture 331 est pratiquée dans la couche isolante 329 pour mettre à nu une région de la couche mince superficielle 304. L'ouverture est réalisée selon des procédés de lithographie mentionnés ci-dessus, et connus en soi. Elle présente, par exemple, une surface de 500 µm x 500 µm. Une implantation d'ions de bore avec une énergie croissante de 0 à 2 MeV et à une dose de 1.10¹⁶ ions/cm³ permet de former un canal 350 de type p+ d'une longueur de l'ordre de 5 µm qui traverse la sous-couche 304a. Le canal 350, visible à la figure 3C, forme une prise de contact sur la sous-couche 304b qui correspond à la zone de contact. La concentration d'impuretés dans le canal est finalement de l'ordre de 10¹⁹ ions/cm³. La couche de nitrure de silicium 329 est ensuite éliminée par gravure chimique avec une solution d'acide fluorhydrique.

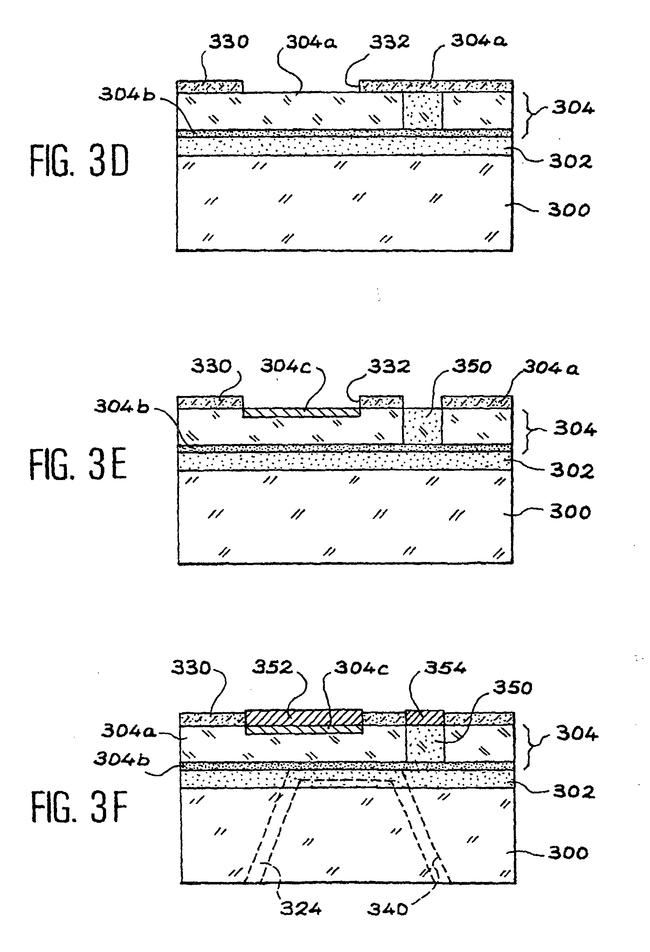

Comme le montre la figure 3D, une étape suivante consiste à former sur la face libre de la couche 304 une nouvelle couche isolante de nitrure de silicium 330, d'une épaisseur de l'ordre de 1 µm. On pratique dans cette couche une ouverture 332 pour mettre a nu une portion de la face libre de la couche superficielle 304, qui correspond à la région de détection. L'ouverture 332 est réalisée selon des procédés connus de lithographie.

Une implantation ionique de phosphore dans l'ouverture 332, avec une énergie de 150 keV et une dose de 1.10¹⁵ ions/cm³ permet de former, comme le montre la figure 3E une région 304c de type n+ et d'une épaisseur de l'ordre de 0,2 µm. Cette région constitue la région de détection au sens de la présente invention. Elle forme avec la couche mince superficielle une jonction redresseuse.

Un recuit de la structure à 1100°C pendant 20 secondes est effectué pour activer les impuretés dopantes et guérir les défauts d'implantation.

La figure 3E montre enfin l'ouverture d'une fenêtre dans la couche 330 au-dessus du canal 350, et la figure 3F montre la réalisation de plots de contact 352, 354 respectivement sur la région 304c et sur le canal 350. Les plots de contact sont réalisés par évaporation d'aluminium. Ils présentent une densité de l'ordre de 100 µg/cm². Le plot de contact 352 d'une part, et le plot 354, associé au canal conducteur 350 décrit précédemment, d'autre part, forment des prises de contact sur les bornes de la diode.

Dans cette réalisation les régions 304c et la sous-couche 304b correspondent respectivement aux couches de jonction et de contact ; la première forme avec la sous-couche 304a la diode de détection. Elles sont polarisées par l'intermédiaire des prises de contact 352, 354, 350 sur lesquels on applique une tension convenable pour polariser la jonction np en inverse. On applique sur la sous-couche 322 une tension négative par l'intermédiaire du canal 350.

Comme indiqué en trait discontinu sur la figure 3F, la prise de contact sur la sous-couche 304b peut être réalisée également par la face arrière selon un procédé semblable au procédé, déjà décrit, de fabrication de contact ohmique du dispositif de la figure 2F. Dans ce cas ou grave localement le substrat de silicium 300 et la couche d'oxyde de silicium 302 pour former une ouverture arrière d'accès 340 à la région de contact, c'est-à-dire la sous-couche 304b.

On forme ensuite une couche de matériau conducteur électrique 324, par exemple d'aluminium, dans l'ouverture arrière, en contact avec la sous-couche 304b. Cette couche de matériau conducteur constitue alors également une prise de contact sur la région de contact de la diode.

Le détecteur obtenu selon ce deuxième procédé présente une bonne tenue mécanique en particulier dans sa version à prise de contact par régions dopées. Il peut être, par exemple, associé à un film en isotope 10 du bore, formé à la surface de l'empilement, pour constituer un détecteur de neutrons. Le film en isotope 10 du bore assure alors la conversion des neutrons en particules alpha. On obtient ainsi un détecteur de neutrons peu sensible au bruit de rayonnement gamma. La juxtaposition d'une pluralité de tels détecteurs équipés d'un film superficiel de bore permet la réalisation de dosimètres sélectifs des neutrons par rapport aux particules gamma.

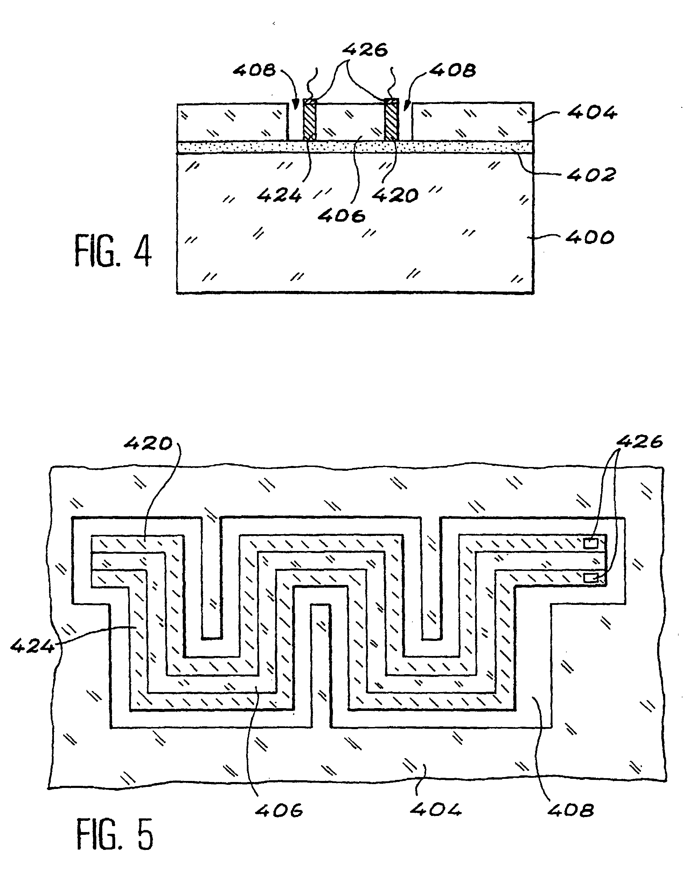

La figure 4 montre une variante de réalisation d'un détecteur conforme à l'invention.

Le détecteur est fabriqué à partir d'une structure SOI comprenant un substrat 400, en silicium dopé d'un type de conductivité n⁻, une couche mince d'oxyde de silicium 402 et d'une couche mince superficielle 404 également en silicium dopé n⁻.

La présente description se réfère explicitement à un transistor fabriqué à partir d'un substrat SOI dont le silicium est du type de conductivité n. Un détecteur équivalent peut être obtenu en remplaçant mutatis mutandis les parties dopées n par des parties dopées p.

Une portion 406 de la couche mince superficielle est électriquement isolée par la couche d'oxyde de silicium 402 et par une tranchée 408 traversant la couche mince superficielle perpendiculairement à sa surface libre, et s'étendant jusque sur la couche d'oxyde 402.

Des régions fortement dopées 420, 424, respectivement de type p⁺ et n⁺ sont formées sur des flancs latéraux opposés de la portion de couche 406. Ces flancs sont sensiblement perpendiculaires à la couche d'oxyde de silicium et parallèles entre eux.

Les régions dopées p⁺ et n⁺ 420, 424 situées sur les flancs latéraux opposés forment respectivement les première et deuxième couches de jonction au sens de la présente invention. En effet, la région n⁺ 424 forme avec la portion 406 de couche mince de type n une jonction dite "ohmique" et la région p⁺ 420 forme avec la portion 406 de couche mince une jonction dite "redresseuse".

Des prises de contact 426 sur les régions 420 et 424, représentées de façon très schématique, forment des électrodes de lecture du détecteur. Elles peuvent être reliées à des moyens de comptage et/ou de spectroscopie appropriée non représentés.

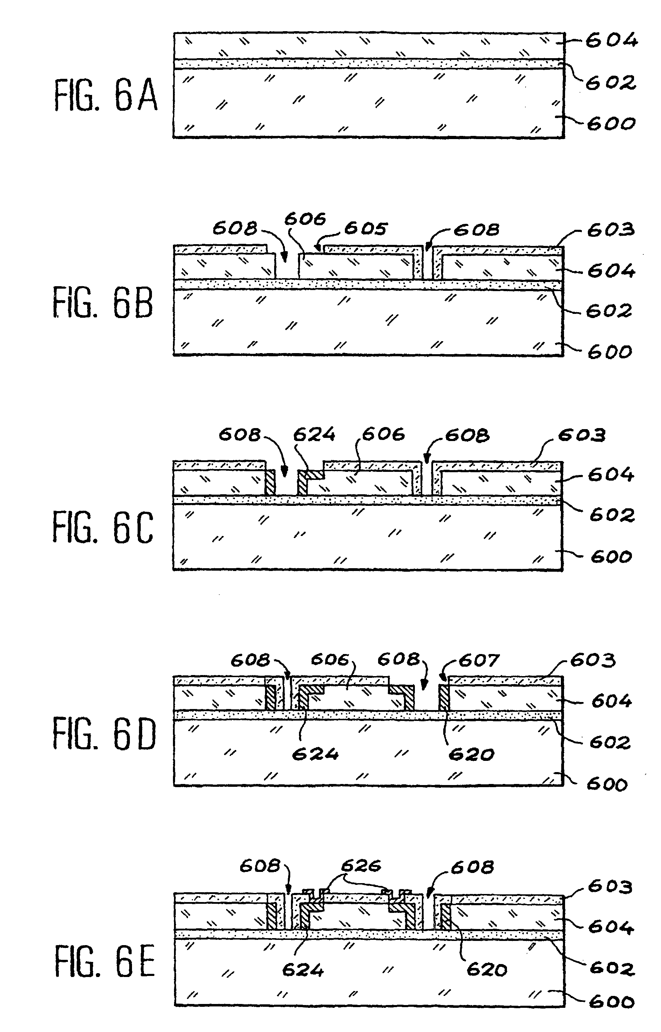

La figure 5 est une vue partielle de dessus de la figure 4. On note cependant que les figures 4 et 5 ne sont pas à la même échelle et que, pour des raisons de clarté, les proportions des différentes parties ne sont pas nécessairement respectées. Sur cette figure on a représenté la portion 406 de couche mince superficielle faisant partie de la diode de détection, les régions 420, 424 formant les première et deuxième couches de jonction sur les flancs de la portion 406 de couche mince, la tranchée 408 et une partie du reste de la couche mince superficielle 404.

Sur cette figure on constate que la portion de couche mince présente une forme en créneaux.

Dans cette réalisation la couche mince superficielle comporte une pluralité de tronçons avec des flancs opposés parallèles entre eux. On constate que les régions 420 et 424 formant les première et deuxième couches de jonction s'étendent sur les flancs opposés de ces tronçons. Les prises de contact sur les régions 420 et 424 sont schématiquement représentées avec la référence 426.

On décrit à présent, en référence aux figures 6A à 6E un troisième mode de fabrication d'un détecteur conforme à l'invention.

Comme le montre la figure 6A, on part d'une structure SOI comprenant un substrat 600 de silicium, une couche mince 602 d'oxyde de silicium et une couche mince superficielle 604 de silicium.

Dans l'exemple décrit, la couche mince superficielle est d'un type de conductivité n. Toutefois, un détecteur similaire peut être obtenu avec une couche de type p. La structure de la figure 6A est comparable à celle de la figure 2A et on peut se reporter à ce sujet à la description qui précède.

Une première étape, illustrée à la figure 6B consiste à graver dans la couche mince superficielle une (ou plusieurs) tranchée(s) 608, sensiblement perpendiculaire(s) à la surface libre de la couche mince superficielle et sensiblement perpendiculaire(s) à la couche 602 d'oxyde de silicium. La tranchée 608 délimite et isole latéralement une portion 606 de la couche mince superficielle faisant partie de la diode de détection.

La portion 606 de couche mince superficielle est également isolée électriquement du substrat 600 par la couche d'oxyde 602.

Une étape suivante comprend l'oxydation thermique de la couche mince superficielle, y compris dans les tranchées. Une couche d'oxyde 603 recouvre ainsi l'ensemble de la couche mince superficielle et en particulier la portion 606 de cette couche.

Une première ouverture 605 pratiquée dans la couche d'oxyde thermique 603 met à nu un premier flanc latéral de la portion 606 de couche mince superficielle. L'ouverture 605 est pratiquée selon des techniques de gravure usuelles telles que la photogravure.

Comme le montre la figure 6C, un dopage est effectué dans l'ouverture 605 pour former une région 624 de type n+ formant une couche jonction sur le flanc mis à nu. Cette couche de jonction est la "deuxième" couche de jonction au sens de la présente invention et est forme avec la portion 606 une jonction dite "ohmique".

Une étape suivante comporte un recuit oxydant permettant notamment de refermer l'ouverture 605 et de protéger la région 624.

Une seconde ouverture 607 est pratiquée dans la couche d'oxyde thermique pour mettre à nu un deuxième flanc latéral opposé de la portion 606 de couche mince superficielle.

Un nouveau dopage, effectué dans l'ouverture 607, permet, comme le montre la figure 6D, de former une région 620 de type p⁺ formant également une couche de jonction. Il s'agit de la "première" couche de jonction dite "redresseuse" au sens de la présente invention.

Une dernière étape comprend un second recuit oxydant pour protéger la région 620 et comprend la formation de prises de contact 626 sur les régions dopées 620 et 624 de la portion 606 de la couche mince superficielle. Ces prises de contact forment des électrodes de polarisation et de lecture de la diode.

On obtient au terme de ce procédé un détecteur semblable à celui de la figure 4 déjà décrite.

## Revendications

1. Détecteur de rayonnements ionisants avec une diode de détection formée dans une couche mince superficielle d'une structure SOI comprenant un empilement d'un substrat de silicium (200, 300, 400, 600) d'une couche isolante d'oxyde de silicium (202, 302, 402, 602) et la couche mince superficielle de silicium (204, 304, 404, 604), la diode comportant une première (220, 304c, 420, 620) et une deuxième (224, 304b, 424, 624) couches, dites de jonction, en contact avec au moins une portion de couche mince superficielle, formant avec ladite portion de couche mince superficielle respectivement une jonction redresseuse et une jonction ohmique et permettant d'établir, par l'application d'une tension, d'un champ électrique de détection dans ladite portion de couche mince, **caractérisé en ce que** les première et deuxième couches de jonction présentent des faces principales en regard et sensiblement parallèles pour établir un champ électrique sensiblement constant entre elles.

2. Détecteur selon la revendication 1, **caractérisé en ce que** ladite première couche de jonction est une couche (220) d'un premier métal disposée en contact avec la face libre de la portion de couche mince superficielle (204) et formant avec cette portion de couche une jonction de type Schottky.

3. Détecteur selon la revendication 1, **caractérisé en ce que** ladite première couche de jonction est une région (304c) de la couche mince superficielle (304) et présente un premier type de conductivité, la région (304c) étant en contact avec une région (304a), dite intermédiaire, de la couche mince superficielle, d'un deuxième type de conductivité opposé au premier type de conductivité, et forme avec celle-ci une jonction de type pn.

4. Détecteur selon l'une des revendications 1 ou 3, **caractérisé en ce que** ladite deuxième couche de jonction est une couche d'un deuxième métal (224) disposée en contact avec une face (226) de la couche mince superficielle, et formant avec la portion de couche superficielle (204) un contact ohmique.

5. Détecteur selon l'une quelconque des revendications 1 à 3, **caractérisé en ce que** ladite deuxième couche de jonction est une région (304b) de la couche mince superficielle, dite région de contact, d'un deuxième type de conductivité opposé au premier type de conductivité, la région de contact étant en contact avec une région intermédiaire (304a) présentant une concentration d'impureté de dopage inférieure à celle de la région de contact.

6. Détecteur selon la revendication 2, **caractérisé en ce que** la portion de couche superficielle comporte une région non intentionnellement dopée en contact avec la couche de premier métal et une région dopée, dite de contact.

7. Détecteur selon les revendications 1, **caractérisé en ce que** la couche superficielle (204) présente une résistivité supérieure à 100 Ω.cm.

8. Détecteur selon la revendication 2, **caractérisé en ce que** le premier métal est de l'or.

9. Détecteur selon la revendication 4, **caractérisé en ce que** le deuxième métal est l'aluminium.

10. Détecteur selon les revendication 2 et 4, **caractérisé en ce que** les couches de premier et de deuxième métal présentent une densité de surface de l'ordre de 40 µg/cm².

11. Détecteur selon l'une au moins des revendications 3 et 5, **caractérisé en ce que** le premier type de conductivité est le type de conductivité n, et le deuxième type de conductivité est le type de conductivité p.

12. Détecteur selon l'une des revendications 1 à 11, **caractérisé en ce qu'**il comporte une prise de contact reliée électriquement à ladite deuxième couche de matériau, et traversant la zone intermédiaire.

13. Détecteur selon l'une quelconque des revendications précédentes, **caractérisé en ce que** la couche mince superficielle (204) présente une épaisseur comprise entre 0,1 et 100 µm.

14. Détecteur selon l'une quelconque des revendications précédentes, **caractérisé en ce que** la couche d'oxyde de silicium (202) présente une épaisseur comprise entre 0,1 et 5 µm.

15. Détecteur selon la revendication 1, **caractérisé en ce que** ladite portion (406, 606) de couche mince superficielle est électriquement isolée et présente au moins deux flancs latéraux opposés, sensiblement parallèles entre eux, et sensiblement perpendiculaires à la couche d'oxyde de silicium, et **en ce que** les première et deuxième couches de matériau de jonction (420, 620, 424, 624) sont respectivement situées sur les flancs latéraux opposés.

16. Détecteur selon la revendication 15, **caractérisé en ce qu'**il présente au moins une tranchée d'isolation (408, 608) entourant la portion (406, 606) de couche mince superficielle.

17. Détecteur selon la revendication 16, **caractérisé en ce que** la portion de couche mince superficielle (406, 606) présente, selon un plan parallèle à la couche d'oxyde de silicium (402, 602), un motif en créneaux.

18. Procédé de fabrication d'un détecteur de rayonnements ionisants conforme à la revendication 1, comprenant les étapes suivantes
• on forme une couche de matériau isolant électrique (230) sur une face libre d'une couche mince superficielle (204) de silicium d'une structure de type silicium sur isolant SOI, la structure comprenant un empilement d'un substrat de silicium (200), d'une couche d'oxyde de silicium (202) et de la couche mince superficielle (204),
• on pratique dans la couche de matériau isolant électrique (230) une ouverture (232) délimitant une zone de détection,
• on forme une première couche (220) de jonction, de matériau conducteur électrique, en contact avec ladite face libre de la couche superficielle (204) dans l'ouverture (232), et formant avec la couche superficielle une jonction de type Schottky,
• on grave localement le substrat de silicium (200) et la couche d'oxyde de silicium (202) pour former une ouverture arrière (240) d'accès à la couche superficielle (204), dans la zone de détection,
• on forme une deuxième couche de jonction, de matériau conducteur électrique (224) en contact avec la couche superficielle dans ladite ouverture arrière d'accès (240), et formant avec la couche superficielle un contact ohmique.

19. Procédé selon la revendication 18, **caractérisé en ce que** le matériau conducteur électrique de la couche de jonction (220), en contact avec la couche mince superficielle (204) dans l'ouverture (232) délimitant la zone de détection, et le matériau conducteur électrique en contact avec la couche superficielle (204) dans l'ouverture arrière d'accès (240) sont respectivement de l'or et de l'aluminium.

20. Procédé selon la revendication 18, **caractérisé en ce que** le matériau isolant électrique est du nitrure de silicium.

21. Procédé selon la revendication 18, **caractérisé en ce que** la couche mince superficielle (204) de silicium présente une résistivité supérieure à 100 Ω.cm.

22. Procédé de fabrication d'un détecteur de rayonnement ionisants conforme à la revendication 1, comportant les étapes suivantes :
a) formation d'une couche de matériau isolant (330) sur une face libre d'une couche superficielle (304) d'une plaque présentant une structure de type SOI et comportant un empilement d'un substrat de silicium (300), d'une couche d'oxyde de silicium (302) et de la couche mince superficielle (304) de silicium, la couche mince superficielle comportant une première région dopée (304a), formant la première couche de jonction, d'un premier type de conductivité et ayant une première concentration d'impuretés, et une deuxième région dopée (304b), formant la deuxième couche de jonction, du même type de conductivité et avec une deuxième concentration d'impuretés supérieure à la première concentration, la deuxième région (304b), en contact avec la couche d'oxyde de silicium, et étant enterrée dans la première région (304a),
b) réalisation dans la couche de matériau isolant électrique (330) d'une ouverture (332) délimitant une zone de détection,
c) dopage de la couche mince superficielle dans la zone de détection pour former une troisième région (304c) avec des impuretés d'un deuxième type de conductivité opposé au premier type de conductivité.
d) recuit thermique de la plaque,
le procédé comportant en outre la formation de prises de contact électrique (352, 354, 350) sur les deuxième et troisième régions dopées.

23. Procédé selon la revendication 22, **caractérisé en ce que** la formation d'une prise de contact électrique sur la deuxième région comporte la réalisation d'un canal conducteur électrique (350) traversant la première région dopée (304a) de la couche mince superficielle (304), le canal conducteur étant réalisé entre les étapes a) et b) du procédé.

24. Procédé selon la revendication 23, **caractérisé en ce que** pour réaliser le canal conducteur (350) :
• on forme une couche (329) de matériau électriquement isolant sur une face libre de la couche superficielle (304),
• on pratique dans la couche (329) de matériau électriquement isolant une ouverture (331) délimitant une zone dite de contact arrière en face de la deuxième région (304b),
• on effectue un dopage de la couche mince superficielle (304) dans la zone de contact arrière pour former un canal (350) en contact électrique avec la deuxième région (304b).

25. Procédé selon la revendication 22, **caractérisé en ce que** la formation d'une prise de contact électrique sur la deuxième région comporte :
- la gravure locale du substrat de silicium (300) et de la couche d'oxyde de silicium (302) pour former une ouverture arrière d'accès (340) à la couche mince superficielle (304) dans la deuxième région dopée (304b)
- la formation d'une couche de matériau conducteur électrique (324) en contact avec la deuxième région dopée (304b) dans ladite ouverture arrière d'accès (340).

26. Procédé selon la revendication 22, **caractérisé en ce que** on réalise les première et deuxième régions dopées avec une conductivité de type p, et la troisième région avec une conductivité de type n.

27. Procédé de fabrication d'un détecteur selon la revendication 15, comportant les étapes suivantes :
- la gravure de la tranchée (608) dans la couche mince superficielle (604) pour délimiter la portion de couche mince superficielle,
- l'oxydation thermique de la couche mince superficielle (604, 606), y compris dans la tranchée,
- la mise à nu d'un premier flanc latéral de la portion de couche mince superficielle,
- le dopage N⁺ du premier flanc mis à nu,
- un premier recuit oxydant,
- la mise à nu d'un deuxième flanc latéral de la portion de couche mince superficielle, opposé au premier flanc,
- le dopage P⁺ du deuxième flanc mis à nu,
- un deuxième recuit oxydant et
- la formation de prises de contact (626) électriques sur les flancs dopés.

## Patentansprüche

1. Detektor für ionisierende Strahlung mit einer Detektionsdiode, ausgebildet in einer Oberflächendünnschicht einer SOI-Struktur mit einem Stapel aus einem Siliciumsubstrat (200, 300, 400, 600), einer Siliciumdioxid-lsolierschicht (202, 302, 402, 602) und der Silicium-Oberflächendünnschicht (204, 304, 404, 604), wobei die Diode eine erste (220, 304c, 420, 620) und eine zweite (224, 304b, 434, 624) Schicht umfasst, Übergangsschichten genannt, die Kontakt haben mit wenigstens einem Teilstück der Oberflächendünnschicht und mit diesem Teilstück der Oberflächendünnschicht jeweils einen gleichrichtenden Übergang und einen ohmschen Übergang bilden und ermöglichen, in dem genannten Teilstück der Dünnschicht durch das Anlegen einer Spannung ein elektrisches Detektionsfeld zu erzeugen,
**dadurch gekennzeichnet,**
**dass** die erste und die zweite Übergangsschicht Hauptflächen aufweisen, die sich gegenüberstehen und im Wesentlichen parallel zueinander sind, so dass das zwischen ihnen erzeugte elektrische Feld im Wesentlichen konstant ist.

2. Detektor nach Anspruch 1, **dadurch gekennzeichnet, dass** die genannte erste Übergangsschicht eine Schicht (220) aus einem ersten Metall ist, abgeschieden in Kontakt mit der freien Fläche des genannten Teilstücks der Oberflächendünnschicht (204), wobei sie mit diesem Teilstück einen Übergang des Schottky-Typs bildet.

3. Detektor nach Anspruch 1, **dadurch gekennzeichnet, dass** die genannte erste Übergangsschicht ein Bereich (304c) der Oberflächendünnschicht (304) ist und einen ersten Konduktivitätstyp aufweist, wobei der Bereich (304c) mit einem so genannten Oberflächendünnschicht-Zwischenbereich (304a) mit einem dem ersten Konduktivitätstyp entgegengesetzten zweiten Konduktivitätstyp Kontakt hat und mit diesem einen Übergang des pn-Typs bildet.

4. Detektor nach einem der Ansprüche 1 oder 3, **dadurch gekennzeichnet, dass** die genannte zweite Übergangsschicht (224) eine Schicht aus einem zweiten Metall ist, die Kontakt hat mit einer Fläche bzw. Seite (226) der Oberflächendünnschicht und mit dem genannten Teilstück der Oberflächendünnschicht (204) einen ohmschen Kontakt bildet.

5. Detektor nach einem der Ansprüche 1 bis 3, **dadurch gekennzeichnet, dass** die genannte zweite Übergangsschicht ein Kontaktbereich genannter Bereich (304b) der Oberflächendünnschicht ist, mit einem dem ersten Konduktivitätstyp entgegengesetzten Konduktivitätstyp, wobei der Kontaktbereich Kontakt hat mit einem Zwischenbereich (304a), der eine niedrigere Konzentration von Dotier-Verunreinigungen aufweist als der Kontaktbereich.

6. Detektor nach Anspruch 2, **dadurch gekennzeichnet, dass** das genannte Teilstück der Oberflächendünnschicht einen nicht absichtlich dotierten Bereich umfasst, der Kontakt hat der Schicht aus dem ersten Metall und einem dotierten Bereich, Kontaktbereich genannt.

7. Detektor nach Anspruch 1, **dadurch gekennzeichnet, dass** die Oberflächenschicht (204) eine Resistivität von mehr als 100 Ω.cm aufweist.

8. Detektor nach Anspruch 2, **dadurch gekennzeichnet, dass** das erste Metall Gold ist.

9. Detektor nach Anspruch 4, **dadurch gekennzeichnet, dass** das zweite Metall Aluminium ist.

10. Detektor nach einem der Ansprüche 2 und 4, **dadurch gekennzeichnet, dass** die Schichten aus dem ersten und zweiten Metall eine Oberflächendichte von ca. 40 µg/cm² aufweisen.

11. Detektor nach einem der Ansprüche 3 und 5, **dadurch gekennzeichnet, dass** der erste Konduktivitätstyp der Konduktivitätstyp n ist und der zweite Konduktivitätstyp der Konduktivitätstyp p ist.

12. Detektor nach einem der Anspruche 1 bis 11, **dadurch gekennzeichnet, dass** er ein Kontaktelement umfasst, das elektrisch mit der zweiten Materialschicht verbunden ist und die Zwischenzone durchquert.

13. Detektor nach einem der vorangehenden Ansprüche, **dadurch gekennzeichnet, dass** Oberflächendünnschicht (204) eine zwischen 0,1 und 100 µm enthaltene Dicke aufweist.

14. Detektor nach einem der vorangehenden Ansprüche, **dadurch gekennzeichnet, dass** die Siliciumdioxidschicht (202) eine zwischen 0,1 und 5 µm enthaltene Dicke aufweist.

15. Detektor nach Anspruch 1, **dadurch gekennzeichnet, dass** das genannte Teilstück (406, 606) der Oberflächendünnschicht elektrisch isoliert ist und wenigstens zwei entgegengesetzte seitliche Flanken aufweist, im Wesentlichen parallel zueinander und im Wesentlichen senkrecht zu der Siliciumdioxidschicht, und dadurch, dass die ersten und die zweiten Übergangsmaterialschichten (420, 620, 424, 624) sich jeweils an den entgegengesetzten seitlichen Flanken befinden.

16. Detektor nach Anspruch 15, **dadurch gekennzeichnet, dass** er wenigstens einen Isolationsgraben (408, 608) aufweist, der das Oberflächendünnschicht-Teilstück (406, 606) umgibt.

17. Detektor nach Anspruch 16, **dadurch gekennzeichnet, dass** das Oberflächendünnschicht-Teilstück (406, 606) in einer zur Ebene der Siliciumdioxidschicht (402, 602) parallelen Ebene ein zinnenförmiges Muster aufweist.

18. Verfahren zur Herstellung eines Detektors für ionisierende Strahlung nach Anspruch 1, das die folgenden Schritte umfasst:
- man bildet eine Schicht aus elektrisch isolierendem Material (230) auf einer freien Fläche einer Silicium-Oberflächendünnschicht (204) einer Struktur des Silicium-auf-lsolator- oder SOI-Typs, die einen Stapel aus einem Siliciumsubstrat (200), einer Siliciumdioxidschicht (202) und der Oberflächendünnschicht (204) umfasst,
- man realisiert in der Schicht aus elektrisch isolierendem Material (230) eine Öffnung (232), die eine Detektionszone abgrenzt,
- man bildet eine erste Übergangsschicht (220) aus elektrisch leitendem Material, die in der Öffnung (232) Kontakt hat mit der genannten freien Fläche der Oberflächenschicht (204) und mit dieser Oberflächenschicht einen Übergang des Schottky-Typs bildet,
- man ätzt das Siliciumsubstrat (200) und die Siliciumdioxidschicht (202) lokal, um in der Detektionszone eine hintere Zugangsöffnung (240) zu der Oberflächenschicht (204) zu schaffen,
- man bildet eine zweite Übergangsschicht aus elektrisch leitendem Material (224), die in der genannten hinteren Zugangsöffnung (240) Kontakt hat mit der Oberflächenschicht und mit dieser Oberflächenschicht einen ohmschen Kontakt bildet.

19. Verfahren nach Anspruch 18, **dadurch gekennzeichnet, dass** das elektrisch leitende Material der Übergangsschicht (220), das in der Öffnung (232), die die Detektionszone abgrenzt, Kontakt hat mit der Oberflächendünnschicht (204), und das elektrisch leitende Material, das in der hinteren Zugangsöffnung (240) Kontakt hat mit der Oberflächenschicht (204 ), jeweils Gold und Aluminium sind.

20. Verfahren nach Anspruch 18, **dadurch gekennzeichnet, dass** das elektrisch isolierende Material Siliciumnitrid ist.

21. Verfahren nach Anspruch 18, **dadurch gekennzeichnet, dass** die Oberflächendünnschicht (204) aus Silicium eine Resistivität aufweist, die höher als 100 Ω.cm ist.

22. Verfahren zur Herstellung eines Detektors für ionisierende Strahlung nach Anspruch 1, das die folgenden Schritte umfasst:
a) man bildet eine Schicht aus elektrisch isolierendem Material (330) auf einer freien Fläche einer Oberflächenschicht (304) eines Plättchens mit einer SOI-Struktur, die einen Stapel aus einem Siliciumsubstrat (300), einer Siliciumdioxidschicht (302) und der Oberflächendünnschicht (304) aus Silicium umfasst, wobei die Oberflächendünnschicht einen ersten dotierten Bereich (304a) umfasst, der die erste Übergangsschicht mit einem ersten Konduktivitätstyp bildet und eine erste Konzentration von Verunreinigungen aufweist, und einen zweiten dotierten Bereich (304b) umfasst, der die zweite Übergangsschicht mit demselben Konduktivitätstyp bildet und eine zweite Konzentration von Verunreinigungen aufweist, die höher ist als die erste Konzentration, wobei der zweite Bereich (304b) Kontakt hat mit der Siliciumdioxidschicht und vergraben ist in bzw. unter dem ersten Bereich (304a),
b) man realisiert in der Schicht aus elektrisch isolierendem Material (330) eine Öffnung (332), die eine Detektionszone abgrenzt,
c) man dotiert die Oberflächendünnschicht in der Detektionszone, um einen dritten Bereich (304c) mit Verunreinigungen eines zum ersten Konduktivitätstyp entgegengesetzten zweiten Konduktivitätstyps zu bilden,
d) Tempern des Plättchens,
wobei das Verfahren außerdem die Bildung von elektrischen Kontaktelementen (352, 354, 350) in dem zweiten und dritten dotierten Bereich umfasst.

23. Verfahren nach Anspruch 22, **dadurch gekennzeichnet, dass** die Bildung eines elektrischen Kontaktelements in dem zweiten Bereich die Realisierung eines elektrisch leitenden Kanals (350) umfasst, der den ersten dotierten Bereich (304a) der Oberflächendünnschicht (304) durchquert, wobei der Kanal zwischen den Schritten a) und b) des Verfahrens realisiert wird.

24. Verfahren nach Anspruch 23, **dadurch gekennzeichnet, dass** der leitende Kanal (350) folgendermaßen realisiert wird:
- man bildet auf einer freien Seite der Oberflächenschicht (304) eine Schicht (329) aus elektrisch isolierendem Material,
- man realisiert in der Schicht (329) aus elektrisch isolierendem Material eine Öffnung (331) die eine so genannte hintere Kontaktzone abgrenzt, dem zweiten Bereich (304b) gegenüberstehend,
- man dotiert die Oberflächendünnschicht (304) in der hinteren Kontaktzone, um einen Kanal (350) zu bilden, der elektrischen Kontakt hat mit dem zweiten Bereich (304b).

25. Verfahren nach Anspruch 22, **dadurch gekennzeichnet, dass** die Bildung eines elektrischen Kontaktelements auf dem zweiten Bereich umfasst:
- das lokale Ätzen des Siliciumsubstrats (300) und der Siliciumdioxidschicht (302), um eine hintere Zugangsöffnung (340) zu der Oberflächendünnschicht (304) in dem zweiten dotierten Bereich (304b) zu schaffen,
- das Bilden einer Schicht aus elektrisch leitendem Material (324), die Kontakt hat mit dem zweiten dotierten Bereich (304b) in der genannten hinteren Zugangsöffnung (340).

26. Verfahren nach Anspruch 22, **dadurch gekennzeichnet, dass** der erste und der zweite dotierte Bereich eine Konduktivität des p-Typs aufweisen und der dritte dotierte Bereich eine Konduktivität des n-Typs.

27. Verfahren zur Herstellung eines Detektors nach Anspruch 15, das die folgenden Schritte umfasst:
- Ätzen des Grabens (608) in die Oberflächendünnschicht (604), um das Oberflächenteilstück abzugrenzen,
- thermisches Oxidieren der Oberflächendünnschicht (604, 606), einschließlich des Grabens,
- Freilegen einer ersten seitlichen Flanke des Oberflächendünnschicht-Teilstücks,
- N⁺-Dotieren der ersten freigelegten Flanke,
- erstes oxidierendes Tempem,
- Freilegen einer der ersten Flanke entgegengesetzten zweiten seitlichen Flanke des Oberflächendünnschicht-Teilstücks,
- P⁺-Dotieren der zweiten freigelegten Flanke,
- zweites oxidierendes Tempem und
- Bilden von elektrischen Kontaktelementen (626) auf den dotierten Flanken.

## Claims

1. Ionizing radiation detector with a detection diode formed in a superficial thin layer of SOI structure comprising a stack made up of a silicon substrate (200, 300, 400, 600), an insulating layer of silicon oxide (202, 302, 402, 602) and the superficial thin layer of silicon (204, 304, 404, 604), the diode comprising a first (220, 304c, 420, 620) and a second (224, 304b, 424, 624) layer, so-called junction layers, in contact with at least one portion of the superficial thin layer, respectively forming with said portion of superficial thin layer a rectifying junction and an ohmic junction allowing to establish, by application of a voltage, an electric detection field in said portion of thin layer, **characterized in that** the first and second junction layers have main faces facing one another that are substantially parallel to establish a substantially constant electric field between them.

2. Detector in accordance with claim 1, **characterized in that** said first junction layer is a layer (220) of a first metal placed in contact with the free face of the portion of superficial thin layer (204) and forming with this portion of layer a junction of Schottky type.

3. Detector in accordance with claim 1, **characterized in that** said first junction layer is a region (304c) of superficial thin layer (304) and has a first type of conductivity, region (304c) being in contact with a so-called intermediate region (304a) of the superficial thin layer having a second type of conductivity opposed to the first type of conductivity, and forming with the latter a PN type junction.

4. Detector in accordance with either of claims 1 or 3, **characterized in that** said second junction layer is a layer of a second metal (224) placed in contact with a face (226) of the superficial thin layer, and forming with the portion of superficial layer (204) an ohmic contact.

5. Detector in accordance with any of claims 1 to 3, **characterized in that** said second junction layer is a region (304b) of the superficial thin layer, so-called contact region, with a second type of conductivity opposed to the first type of conductivity, the contact region being in contact with an intermediate region (304a) having a doping impurity concentration lower than that of the contact region.

6. Detector in accordance with claim 2, **characterized in that** the portion of superficial layer comprises an unintentionally doped region in contact with the layer of first metal and a doped, so-called contact, region.

7. Detector in accordance with claim 1, **characterized in that** the superficial layer (204) has a resistivity of more than 100 Ω.cm.

8. Detector in accordance with claim 2, **characterized in that** the first metal is gold.

9. Detector in accordance with claim 4, **characterized in that** the second metal is aluminium.

10. Detector in accordance with claims 2 and 4, **characterized in that** the layers of first and second metal have a surface density in the region of 40 µg/cm².

11. Detector in accordance with at least one of claims 3 and 5, **characterized in that** the first type of conductivity is N type conductivity, and the second type of conductivity is P type conductivity.

12. Detector in accordance with any of claims 1 to 11, **characterized in that** it comprises a contact point electrically connected to said second layer of material, crossing the intermediate zone.

13. Detector in accordance with any of the preceding claims, **characterized in that** the superficial thin layer (204) is between 0.1 and 100 µm thick.

14. Detector in accordance with any of the preceding claims, **characterized in that** the layer of silicon oxide (202) is between 0.1 and 5 µm thick.

15. Detector in accordance with claim 1, **characterized in that** said portion (406, 606) of superficial thin layer is electrically insulated and has at least two opposite sides, substantially parallel to one another, and substantially perpendicular to the layer of silicon oxide, and **in that** the first and second layers of junction material (420, 620, 424, 624) are respectively located on the opposite sides.

16. Detector in accordance with claim 15, **characterized in that** it has at least one insulating groove (408, 608) surrounding the portion (406, 606) of superficial thin layer.

17. Detector in accordance with claim 16, **characterized in that** the portion of superficial thin layer (406, 606) has, along a plane parallel to the layer of silicon oxide (402, 602), a notched pattern.

18. Process of manufacturing an ionizing radiation detector in accordance with claim 1, comprising the following stages:
· a layer of electric insulating material is formed on a free face of a superficial thin layer (204) of silicon having a structure of silicon-on -insulator type SOI, the structure comprising a stack made up of a silicon substrate (200), a layer of silicon oxide (202) and superficial thin layer (204),
· in electric insulating material (230) an opening (232) is made forming the boundary of a detection zone,
· a first junction layer (220) is formed, in electric conductor material, in contact with said free face of the superficial layer (204) in opening (232), and forming with the superficial layer a junction of Schottky type,
· silicon substrate (200) and the layer of silicon oxide (2020 are locally etched to form a rear access opening (240) to the superficial layer (204), in the detection zone,
· a second junction layer is formed, in electric conductor material (224), in contact with the superficial layer in said rear access opening (240), forming an ohmic contact with the superficial layer.

19. Process in accordance with claim 18, **characterized in that** the electric conductor material of junction layer (220), in contact with superficial thin layer (204) in opening (232) bordering the detection zone, and the electric conductor material in contact with superficial layer (204) in rear access opening (240) are gold and aluminium respectively.

20. Process in accordance with claim 18, **characterized in that** the electric conductor material is silicon nitride.

21. Process in accordance with claim 18, **characterized in that** the resistivity of the superficial thin layer (204) of silicon is more than 100 Ω.cm.

22. Process of manufacturing an ionizing radiation detector in accordance with claim 1, comprising the following stages:
a) forming a layer of insulating material (330) on one free face of a superficial layer (304) of a wafer having a structure of SOI type and comprising a stack made up of a silicon substrate (300), layer of silicon oxide (302) and superficial thin layer (304) of silicon, the superficial thin layer comprising a first doped region (304a), forming the first junction layer, having a first type of conductivity and a first impurity concentration, and a second doped region (304b) forming the second junction layer, having the same type of conductivity and a second concentration of impurities higher than the first concentration, the second region (304b) being in contact with the layer of silicon oxide and being embedded in the first region (304a),
b) making, in the layer electric insulating material (330), an opening (332) which borders the detection zone,
c) doping the superficial thin layer in the detection zone to form a third region (304c) with impurities having a second type of conductivity opposed to the first type of conductivity,
d) heat annealing the wafer,
the process also comprising the formation of electric contact points (352, 354, 350) on the second and third doped regions.

23. Process in accordance with claim 22, **characterized in that** the formation of an electric contact point on the second region comprises the fabrication of an electric conductor channel (350) crossing the first doped region (304a) of superficial thin layer (304), the conductor channel being made between stages a) and b) of the process.

24. Process in accordance with claim 23, **characterized in that** to fabricate conductor channel (350):
· a layer (329) of electric insulating material is formed on one free face of the superficial layer (304),
· in layer (329) of electric insulating material an opening (331) is made, bordering a so-called rear contact zone opposite the second region (304b),
· superficial thin layer (304) is doped in the rear contact zone to form a channel (350) in electric contact with the second region (304b).

25. Process in accordance with claim 22, **characterized in that** the formation of an electric contact point on the second region comprises:
- locally etching silicon substrate (300) and the layer of silicon oxide (302) to form a rear access opening (340) to superficial thin layer (304) in the second doped region (304b),
- forming a layer of electrical conductor material (324) in contact with the second doped region (304b) in said rear access opening (304).

26. Process in accordance with claim 22, **characterized in that** the first and second doped regions are made with P-type cpnductivity, and the third region with N-type conductivity.

27. Process for manufacturing a detector in accordance with claim 15, comprising the following stages:
- cutting groove (608) in the superficial thin layer (604) to border the portion of superficial thin layer,
- heat oxidizing the superficial thin layer (604, 606) including in the groove,
- exposing a first side of the portion of superficial thin layer,
- N+ doping the first exposed side,
- initial oxidizing annealing,
- exposing a second side of the portion of superficial thin layer, opposite the first side,
- P+ doping the second exposed side,
- second oxidizing annealing, and
- forming electric contact points (626) on the doped sides.
